Europäisches Patentamt

European Patent Office

Office européen des brevets

(19)

(11) Veröffentlichungsnummer : **0 050 701**
**B1**

(12) EUROPÄISCHE PATENTSCHRIFT

(45) Veröffentlichungstag der Patentschrift :
**13.06.84**

(21) Anmeldenummer : **81102304.3**

(22) Anmeldetag : **27.03.81**

(51) Int. Cl.$^3$ : **B 23 K   3/00**

(54) Vorrichtung zum Auslöten elektronischer Bauteile aus Leiterplatten.

(30) Priorität : **23.10.80 DE 3040274**

(43) Veröffentlichungstag der Anmeldung :
**05.05.82 Patentblatt 82/18**

(45) Bekanntmachung des Hinweises auf die Patenterteilung : **13.06.84 Patentblatt 84/24**

(84) Benannte Vertragsstaaten :
**AT CH FR GB IT LI NL**

(56) Entgegenhaltungen :
**US-A- 3 245 598**
**US-A- 3 377 689**
**US-A- 3 435 801**
**US-A- 3 766 623**
**US-A- 4 187 973**
**Prospekt: ZEVAC Auslötmaschine PCBRM-6 für
Industrie und Service**

(73) Patentinhaber : **ERSA Ernst Sachs KG GmbH & Co.
Leonhard-Karl-Strasse 24
D-6980 Wertheim / Main (DE)**

(72) Erfinder : **Fuchs, Gottfried
Am Roten Rain 4
D-6981 Dorfprozelten (DE)**
Erfinder : **Garrecht, Ewald
Lange Bäun 7
D-6980 Wertheim-Sachsenh. (DE)**
Erfinder : **Rieck, Lothar
Eichelgasse 51
D-6980 Wertheim (DE)**
Erfinder : **Rüppel, Wolfgang
Im Hirtengarten 6
D-6983 Kreuzwertheim Röttbach (DE)**
Erfinder : **Schwarz, Rudolf, Ing.grad.
Hülbe-Weg 20
D-7141 Schwieberdingen (DE)**
Erfinder : **Siegle, Erich, Ing. grad.
Freiherr-von-Tessin-Strasse 23
D-7147 Eberdingen-Hochdorf (DE)**

(74) Vertreter : **Lüke, Dierck-Wilm, Dipl.-Ing.
Gelfertstrasse 56
D-1000 Berlin 33 (DE)**

## Beschreibung

Die Erfindung bezieht sich auf eine Vorrichtung zum Auslöten elektronischer Bauteile aus Leiterplatten gemäss dem Oberbegriff des Anspruches 1. Mit derartigen Vorrichtungen sollen falsch eingelötete oder defekte Bauteile ausgelötet werden. Daneben kann mit derartigen Vorrichtungen regelmässig ein neues Bauteil eingelötet werden.

Bei einer bekannten Vorrichtung der gattungsgemässen Art wird über eine an die Abmessungen des Bauteiles angepaßte Lotdüse flüssiges Lot an die Unterseite der Leiterplatten zugeführt. Wenn alle Lötverbindungen der Leiterplatte aufgeschmolzen sind, kann das Bauteil entfernt werden, wozu dieses mit seinen Bauteilbeinchen nach oben aus der Leiterplatte von Hand oder mittels eines Greifwerkzeuges herausgezogen wird. Im Anschluss daran wird von oben eine Luftdüse auf der nun freien Bauteilfläche der Leiterplatte plaziert. Mittels eines geringen überdruckes werden die Bohrungen der Leiterplatte nach unten freigeblasen, wobei Lotreste nach unten in die Lotdüse geblasen werden. Die Luftdüse hat die gleichen Innenabmessungen wie die Lotdüse und dient gleichzeitig der Positionierung, da diese mit der Anordnung der unterhalb der Leiterplatte angeordneten Lotdüse übereinstimmt.

Zum Einlöten kann ein neues Bauteil in die freien Bohrungen der Leiterplatte gesteckt und mittels der durch die Lotdüse nach oben geführten Lotschmelze mit den Anschlüssen der Leiterplatte verlötet werden.

Die bekannte Vorrichtung hat den Nachteil, dass bei sehr eng mit Bauteilen bestückten Leiterplatten kein Platz für die aufzusetzende Luftdüse vorhanden ist. Ferner sind bei einer Änderung der Abmessungen der auszulötenden elektronischen Bauteile sowohl die Luftdüse als auch die Lötdüse auszuwechseln, da beide an die Abmessungen der auszulötenden elektronischen Bauteile anzupassen sind. Schliesslich ist die Zeitspanne zwischen dem Herausnehmen des ausgelöteten elektronischen Bauteiles aus der Leiterplatte und dem Ausblasen der Öffnungen mittels der Luftdüse relativ gross, da erst nach dem Herausnehmen des ausgelöteten elektronischen Bauteiles die Luftdüse aufgesetzt werden kann. Diese relativ grosse Zeitspanne ist für einen schnellen Arbeitsablauf hinderlich. Insbesondere besteht hierdurch die Gefahr, dass bereits Lotreste erkaltet und nicht mehr aus den Öffnungen herausblasbar sind.

Der Erfindung liegt von daher die Aufgabe zugrunde, eine Vorrichtung zum Auslöten elektronischer Bauteile aus Leiterplatten und gleichzeitig auch zum Wiedereinlöten von Bauteilen gemäss der Gattung des Anspruches 1 zu schaffen, bei welcher die Anzahl der auszuwechselnden Vorrichtungsteile zur Anpassung an die Abmessungen eines auszulötenden elektronischen Bauteiles möglichst gering gehalten ist, bei welcher die Einrichtung zum Entfernen von Lotresten aus den Bohrungen der Leiterplatte derart getroffen ist, dass keine Raumprobleme bei eng bestückten Leiterplatten auftreten und bei welcher schliesslich eine möglichst geringe Zeitspanne zwischen dem Herausnehmen des Bauteils und dem Entfernen der Lötreste aus den Bohrungen der Leiterplatte möglich ist.

Die Lösung dieser Aufgabe ergibt sich aus den kennzeichnenden Merkmalen des Anspruches 1. Durch die Anordnung der Einrichtung zum Entfernen von Lotresten aus den Bohrungen der Leiterplatte auf der Unterseite der Leiterplatte und durch deren Ausbildung als Unterdruckraum mit der Absaugungsöffnung in Form des an die Abmessungen des auszulötenden Bauteils angepassten Einsatzteiles und schliesslich mit der Verwendung dieses Einsatzteiles als Begrenzungsteil für den aus der mit Abstand unterhalb des Einsatzteiles angeordneten Lötdüse austretenden Lotstrom wird zum einen ermöglicht, dass nur ein Vorrichtungsteil, nämlich das Einsatzteil die Funktionen der im Stand der Technik verwendeten Lotdüse und gleichzeitig der Luftdüse übernimmt, daß ferner die Abmessungen dieses Einsatzteiles, die zwar an die Abmessungen des elektronischen Bauteiles angepasst sind, unabhängig davon sind, welcher Raum auf der Oberseite der Leiterplatte zwischen den dort befindlichen weiteren Bauteilen vorhanden ist, und dass schliesslich nur eine geringe Zeitspanne vergeht zwischen dem Zeitpunkt der Herausnahme des ausgelöteten elektronischen Bauteiles nach oben und dem Aufbringen des Absaugungsunterdruckes zur Entfernung der Lotreste aus den nun freien Bohrungen der Leiterplatte.

Eine bevorzugte Ausführungsform der Erfindung ergibt sich aus den Unteransprüchen. Hierbei ist insbesondere die Ausbildung des Einsatzteiles innerhalb eines auswechselbaren Maskeneinsatzes hervorzuheben. Zur Anpassung der Vorrichtung an andere Abmessungen eines auszulötenden elektronischen Bauteiles muss lediglich dieser Maskeneinsatz mit die Absaugungsöffnung bildendem Einsatzteil ausgewechselt werden.

Zur einfachen Markierung des auszulötenden elektronischen Bauteiles ist oberhalb des Maskeneinsatzes ein Markierungsprojektor zum Einsetzen von Markierungsbildern vorgesehen, dessen Strahlengang das auszulötende elektronische Bauteil markiert.

Aus der US 4 187 973 ist ein gattungsfremdes Hand- Entlötgerät vorbekannt, welches am Ende eines an eine Unterdruckeinrichtung angeschlossenen Gehäuses eine Entlötspitze aufweist, welche mit einer Vielzahl von Saugbohrungen versehen ist. Diese sind in ihrem Abstand voneinander an die Abstände der Anschlussdrähte der auszulötenden Bauteile angepasst. Die Entlötspitze wird elektrisch beheizt. Mit diesem gattungsfremden Hand- Entlötgerät können zwar einzelne Bauteile aus einer Leiterplatte ausgelötet, jedoch nicht wieder eingelötet werden. Ferner dürfen die Anschlussdrähte der Bauteile nicht verbogen sein, da diese dann nicht in die Absaugungsöffnungen der Entlötspitze hineinpassen. Diese muss selbst dann bei gleichen äusseren Abmessungen unterschiedlicher elektronischer Bauteile ausgewechselt werden, wenn diese Bauteile unterschiedliche Anzahlen und/ oder Anordnungen von Anschlussdrähten haben.

Die Erfindung ist nachfolgend anhand eines in den Zeichnungen dargestellten Ausführungsbeispieles näher erläutert. Es zeigen :

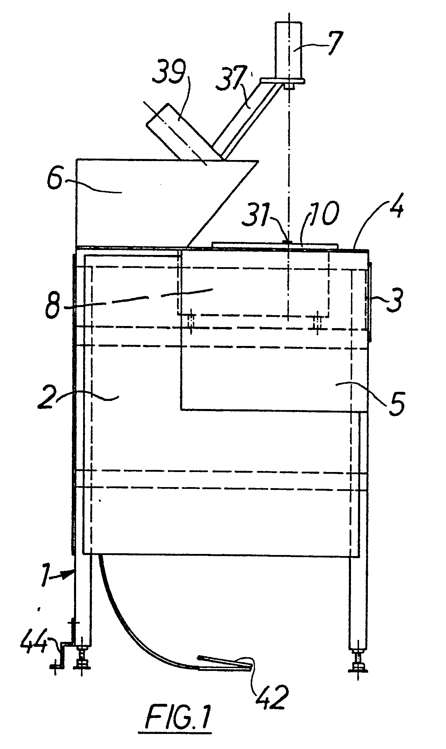

Figur 1 eine Seitenansicht der Vorrichtung,

Figur 2 eine Vorderansicht mit gestrichelt eingezeichneten Vorrichtungsaggregaten,

Figur 3 eine Draufsicht auf die Vorrichtung,

Figur 4 einen Prinzipschnitt durch die wesentlichen Vorrichtungteile,

Figur 5 eine vergrösserte Darstellung der Einzelheit X in Fig. 4 und

Figur 6 einen Schnitt gemäß der Linie A-B in Figur 4.

Die Vorrichtung zum Auslöten elektronischer Bauteile aus Leiterplatten umfasst einen Grundaufbau aus einem vierbeinigen Grundgestell 1, allseitigen Blechverkleidungen 2, einer Wärmeabschirmung 3 auf der Bedienseite, einer Arbeitsplatte 4 mit einem leitfähigen Belag, einem Schaltpult 5 mit einer elektronischen Steuerung, einer oberhalb der Arbeitsplatte 4 angeordneten Absaugungseinrichtung 6 und einem Markierungsprojektor 7. Ein Ableitblech 44 gewährleistet die MOS-Sicherheit der Arbeitsplatte 4. Ein Not-Aus-Schalter 45 ist im Griffbereich der Bedienungsperson an der Arbeitsplatte 4 befestigt.

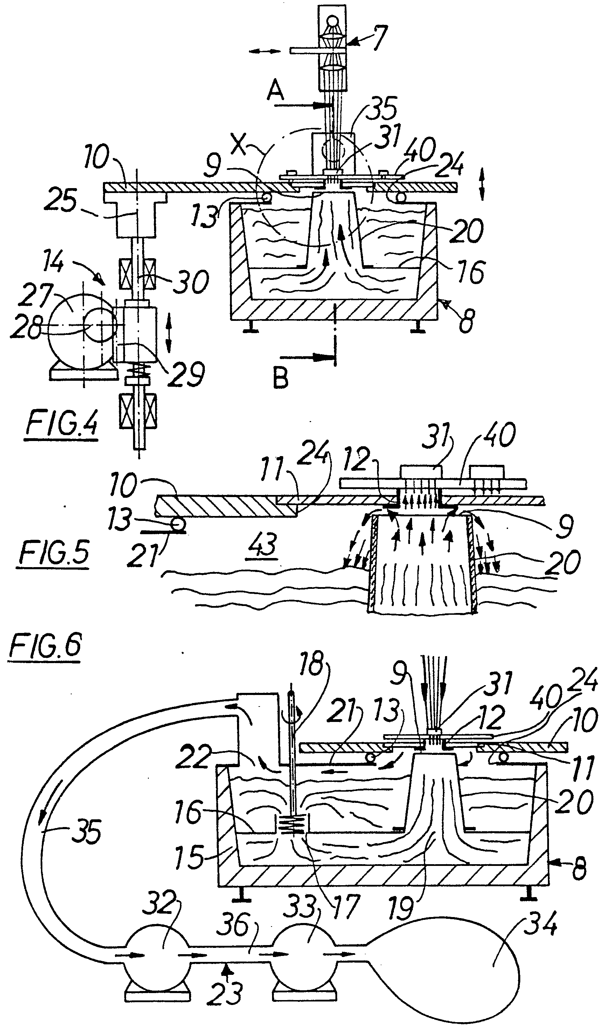

In der Ebene und unterhalb der Arbeitsplatte 4 sind zwischen den Blechverkleidungen 2 des Grundgestelles 1 die eigentlichen Vorrichtungteile untergebracht, die in den Fig. 4 bis 6 in Prinzipdarstellungen näher dargestellt sind. Diese umfassen ein Lötgerät 8 mit Lötdüse 9, einen in der Ebene der Arbeitsplatte 4 angeordneten heb- und senkbar gelagerten Maskenrahmen 10 zur Aufnahme von Maskeneinsätzen 11 mit Einsatzteilen 12, eine Dichtung 13 zwischen den oberen Begrenzungsflächen des Gehäuses 15 des Lötgerätes 8 und der Unterseite des Maskenrahmens 10, sowie einen Hub- Senkmechanismus 14 für den Maskenrahmen 10.

Das Lötgerät 8 besteht aus einem wärmebeständigem und wärmeisolierten Gehäuse 15, dessen Innenraum durch eine horizontale Trennwand 16 unterteilt ist. Diese weist zum einen eine Loteinströmöffnung 17 mit einer Rotations- Umwälz-Schneckenpumpe 18 und eine weitere Öffnung 19 auf, an welche sich ein Schacht 20 anschliesst, der oben in der Lötdüse 9 mündet. Diese hat einen konstanten Querschnitt, insbesondere einen rechteckigen Querschnitt, der grösser ist, als die Abmessungen des grössten auszulötenden elektronischen Bauteils 31. Mittels der Pumpe 18 wird das oberhalb der Trennwand 16 befindliche Lot durch den Schacht 20 nach aufwärts gedrückt und tritt aus der Lötdüse 9 als Lötschwall aus, wie es insbesondere in Fig. 5 durch Pfeile dargestellt ist. Das Gehäuse 15 des Lötgerätes 8 ist obengasdicht durch eine Deckplatte 21 abgeschlossen, welche eine Anschlussöffnung 22 für eine Absaugungseinrichtung 23 und eine Arbeitsöffnung 24 aufweist, welche von dem Schacht 20 der Lötdüse 9 durchdrungen ist. Um diese Arbeitsöffnung 24 herum ist die Dichtung 13 angeordnet, welche den oberhalb des Lotbades innerhalb des Gehäuses 15 des Lötgerätes 8 befindlichen Luftraum hermetisch abschliesst, sobald der heb- und senkbare Maskenrahmen 10 aufgesetzt ist.

Der Maskenrahmen 10 ist unmittelbar oberhalb der Ebene der Arbeitsplatte 4 um ein Schwenklager 25 mit vertikaler Achse drehbar und liegt in seiner Arbeitsstellung an einem Führungsprisma 26 an, das oberhalb der Arbeitsplatte 4 und an dieser befestigt ist. Der Maskenrahmen 10 besteht aus Epoxidharz. Er ist mittels des Hub- und Senkmechanismus 14 vertikal heb- und senkbar gelagert. Der Mechanismus 14 besteht aus einem Antriebsmotor 27 in Form eines Drehstrom-Getriebebremsmotors, einer Ritzelwelle mit Ritzel 28 und einer Zahnstange 29, die an einer vertikalen, den Maskenrahmen 10 führenden Welle 30 befestigt ist, die schwenkbar und vertikal hin- und herbewegbar innerhalb des Grundgestelles 1 gelagert ist.

Der mittels der Dichtung 13 gegenüber dem Gehäuse 15 des Lötgerätes 8 im abgesenkten Zustand abgedichtete Maskenrahmen 10 trägt innerhalb einer Öffnung auswechselbar eingesetzte Maskeneinsätze 11, die ebenfalls aus Epoxidharz ausgebildet sind. Diese weisen wiederum innerhalb einer Öffnung das Einsatzteil 12 auf, das aus Stahl gebildet und innen mit Weicheisen belegt ist. Der Maskeneinsatz 11 mit Einsatzteil 12 befindet sich auch im abgesenkten Zustand des Maskenrahmens 10 oberhalb von und in einem Abstand zur Lötdüse 9 des Lötgerätes 8. Das Einsatzteil 12 ist an die Abmessungen des auszulötenden elektronischen Bauteiles 31 angepasst, das unmittelbar oberhalb der über die Oberfläche des Maskeneinsates 11 hinausragenden Wandteile des Einsatzteiles 12 aufgenommen ist.

Innerhalb des Grundgestelles 1 ist zwischen dessen Blechverkleidungen 2 die Absaugungseinrichtung 23 angeordnet, die aus zwei hintereinander geschalteten Gebläsen 32, 33 und einem nachgeschaltetem Staubbeutel 34 zur Aufnahme der Lotreste gebildet ist, wobei metallische Absaugleitungen 35, 36 zwischen der Anschlussöffnung 22 des Gehäuses 15 und die Gebläse 32, 33 eingesetzt sind.

Der oberhalb der Arbeitsplatte 4 an einem Ständer 37 befestigte Markierungsprojektor 7 kann mit auswechselbaren Markierungsbildern bestückt werden, deren Lichtsymbole eine Fixierstrahlung auf den Maskeneinsatz 11 und dessen Einsatzteil 12 richten, wodurch das auszulötende Bauteil 31 bzw. eine an dessen Stelle wieder einzulötendes Bauteil markiert werden können. Am Ständer 37 ist ein Flussmittelbecher 38 angeordnet.

Die oberhalb der Arbeitsplatte 4 noch angebrachte Absaugungseinrichtung 6 dient zum Absaugen schädlicher Dämpfe in ein Absaugnetz, das an einen Absaugstutzen 39 angeschlossen ist.

Das am Grundgestell 1 befestigte Schaltpult 5 beinhaltet eine komplette elektronische Steuerung zur Durchführung sämtlicher Bewegungsabläufe einer Arbeitsoperation zum Auslöten, die nachfolgend beschrieben wird, und zum Wiedereinlöten.

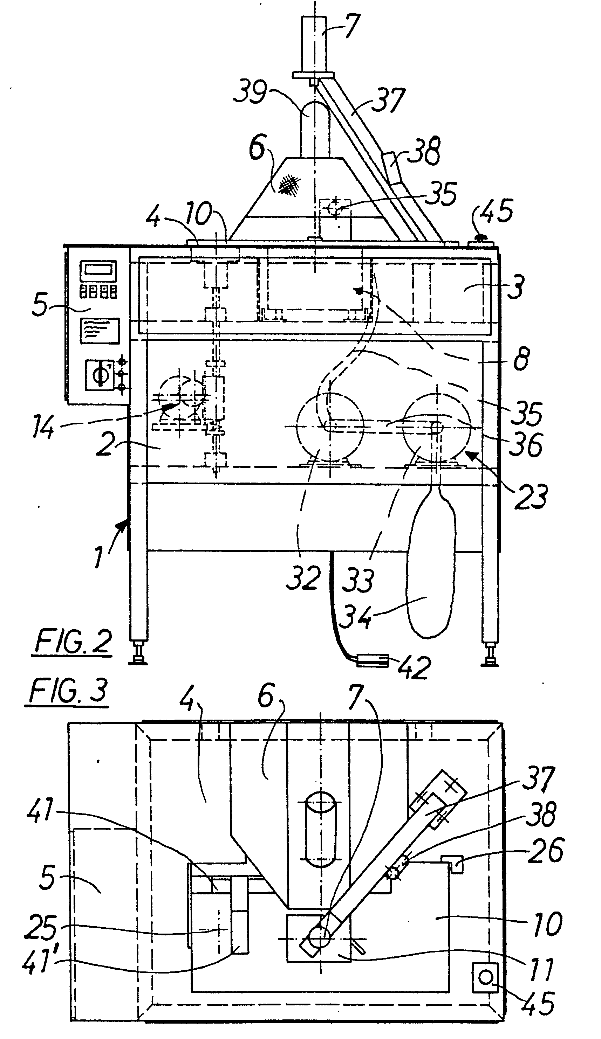

Für eine Arbeitsoperation zum Auslöten eines elektronischen Bauteiles 31 aus einer Leiterplatte 40 muss zunächst das Lotbad innerhalb des Lötgerätes 8 aufgeheizt werden, wozu in diesem nicht näher dargestellte Heizeinrichtungen untergebracht sind. Sobald die Lötwelle in der in Fig. 5 prinzipiell dargestellten Form aus der Lötdüse 9 austritt, kann mit dem Auslöten begonnen werden. Hierzu wird auf den Auslötbereich der Leiterplatte 40 Flussmittel aus dem Flussmittelbecher 38 aufgetragen und die Leiterplatte 40 wird mit den Bauteilbeinchen nach unten auf den Maskenrahmen 10 bzw. Maskeneinsatz 11 aufgesetzt, wobei Anschlagleisten 41, 41' (Fig. 3) eine genaue Positionierung ermöglichen. Das nun oberhalb der Leiterplatte 40 befindliche auszulötende Bauteil 31 wird mittels des Markierungsprojektors 7 und dessen Fixierstrahlen markiert. Ein nicht dargestelltes Abziehwerkzeug wird auf das auszulötende Bauteil 31 aufgesetzt. Ein Fußschalter 42 wird betätigt, woraufhin sich der Maskenrahmen 10 unter Wirkung des Hub- Senkmechanismus 14 absenkt. Hierdurch wird zum einen der Unterdruckraum 43 oberhalb des Lotbades und innerhalb des Lötgerätes 8 mittels der Dichtungen 13 abgedichtet und zum anderen kommen die verlöteten Bauteilbeinchen des Bauteiles 31 in den Bereich der aus der Lötdüse 9 austretenden Lötwelle, wodurch die Lötstellen aufgeschmolzen werden Gleichzeitig läuft ein in der elektronischen Steuerung des Schaltpultes 5 enthaltenes Zeitglied für die Wellenabschaltung an. Der Maskenrahmen 10 verharrt in seiner unteren Stellung und die Bauteilbeinchen werden mit Lot angespült und die Lötstelle aufgeschmolzen. Dann wird das Bauteil 31 von Hand mittels des Hilfswerkzeuges oder von einer nicht dargestellten hierzu geeigneten Vorrichtung aus der Leiterplatte 40 herausgenommen. Sobald das Zeitglied für die Entlötdauer abgelaufen ist, wird die Lötwelle abgeschaltet und die Unterdruckeinrichtung 23 eingeschaltet, wobei gleichzeitig wiederum ein Zeitglied für die Einschaltdauer der Unterdrucksaugeinrichtung 23 anläuft. Somit können die Öffnungen innerhalb der Leiterplatte 40, in welche die Bauteilbeinchen des ausgelöteten Bauteiles 31 hineinragten, unverzüglich nach dessen Herausziehen von Lötresten freigesaugt werden. Sobald das Zeitglied für die Unterdruck- Saugeinrichtung 23 abgelaufen ist, wird der Maskenrahmen angehoben und die Lotwelle wieder eingeschaltet. Es kann nun ein neues Bauteil eingesetzt und durch erneutes Absenken des Maskenrahmens 10 eingelötet werden.

Bei einem Wechsel in der Grösse der auszulötenden Bauteile 31 ist lediglich der Maskeneinsatz 11 mit dem Einsatz 12 herauszunehmen und durch einen an das neue Bauteil 31 angepassten Maskeneinsatz mit entsprechendem Einsatzteil 12 auszuwechseln. Dann kann sofort ein weiterer Arbeitsvorgang zum Auslöten beginnen.

## Ansprüche

1. Vorrichtung zum Auslöten elektronischer Bauteile aus Leiterplatten (40), mit einer auf der Unterseite der zugeführten Leiterplatten (40) angeordneten Lotdüse (9) zur Zufuhr von flüssigem Lot an die Lötverbindungen der Leiterplatten (40) und mit einer Einrichtung zum Entfernen von Lotresten aus den Bohrungen der Leiterplatten (40), dadurch gekennzeichnet, dass die Einrichtung zum Entfernen von Lotresten aus einem auf der Unterseite der zugeführten Leiterplatten (40) angeordneten Unterdruckraum (43) und aus einem eine Absaugungsöffnung des Unterdruckraumes (43) bildenden, an die Abmessungen des auszulötenden Bauteiles (31) angepassten Einsatzteil (12) gebildet ist, und dass die Absaugungsöffnung des Einsatzteiles (12) über und mit einem derartigen Abstand zu der Lotdüse (9) angeordnet ist, dass eine Begrenzung für den unterhalb des Einsatzteiles (12) austretenden Lotstrom gebildet wird.

2. Vorrichtung nach Anspruch 1, dadurch gekennzeichnet, dass der Unterdruckraum (43) aus einem ein Lötgerät (8) mit Lötdüse (9) zur Erzeugung des Lotstromes einer Auslötwelle bildenden Gehäuse (15) und einem im Abstand zur Lötdüse (9) angeordneten und auf diese abgedichtet aufgesetzten, das Einsatzteil (12) aufnehmenden Maskenrahmen (10) gebildet und mit einer Einrichtung (23) zur Erzeugung des Unterdrucks verbunden ist.

3. Vorrichtung nach Anspruch 2, dadurch gekennzeichnet, dass der Maskenrahmen (10) heb- und senkbar gelagert ist und eine Öffnung für einen auswechselbaren, das Einsatzteil (12) aufnehmenden Maskeneinsatz (11) aufweist.

4. Vorrichtung nach Anspruch 3, dadurch gekennzeichnet, dass das Einsatzteil (12) aus Stahl mit einer Weicheisenwandung ausgebildet ist.

5. Vorrichtung nach Anspruch 2 oder 3, dadurch gekennzeichnet, dass der Maskenrahmen (10) und der Maskeneinsatz (11) aus Epoxidharz ausgebildet sind.

6. Vorrichtung nach einem der vorangegangenen Ansprüche, dadurch gekennzeichnet, dass oberhalb des Maskeneinsatzes (12) ein Markierungsprojektor (7) zur Kennzeichnung des auszulötenden Bauteiles (31) mittels eines Markierungsbildes angeordnet ist.

## Claims

1. Apparatus for desoldering electronic components from printed circuits (40), with a solder nozzle (9) located on the underside of the supplied printed circuits (40) for feeding liquid solder to the soldered joints of the printed circuits (40) and with a device for removing remnants of solder from the bores in the printed circuits (40), characterised in that the device for removing remnants of solder consists of a vacuum space (43), located on the underside of the supplied printed circuits (40), and of an insert part (12) forming an extraction orifice in the vacuum space (43) and matching the dimensions of the component (31) to be desoldered, and that the extraction orifice of the insert part (12) is located above the solder nozzle (9) and at such a distance from it that a limitation for the stream of solder flowing out underneath the insert part (12) is formed.

2. Apparatus according to Claim 1, characterised in that the vacuum space (43) consists of a housing (15), forming a soldering device (8) with a solder nozzle (9) for producing the stream of solder in a desoldering wave, and of a mask frame (10), located at a distance from the solder nozzle (9), placed over the latter so as to be sealed off and receiving the insert part (12), and is connected to a device (23) for generating the vacuum.

3. Apparatus according to Claim 2, characterised in that the mask frame (10) is mounted so that it can be lifted and lowered and has an orifice for an exchangeable mask insert (11) receiving the insert part (12).

4. Apparatus according to Claim 3, characterised in that the insert part (12) is made of steel with a soft-iron wall.

5. Apparatus according to Claim 2 or 3, characterised in that the mask frame (10) and the mask insert (11) are made of epoxy resin.

6. Apparatus according to one of the preceding claims, characterised in that a marking projector (7) for identifying the component to be desoldered (31) by means of a marking pattern is located above the mask insert (12).


**Revendications**

1. Dispositif pour dessouder des composants électroniques de plaquettes (40) à circuits imprimés, comportant une buse de soudage (9) située à la face inférieure des plaquettes (40) à circuits imprimés qui ont été acheminées, en vue d'admettre de la soudure liquide dans les liaisons par soudage desdites plaquettes (40) à circuits imprimés, ainsi qu'un dispositif pour supprimer des résidus de soudure des trous desdites plaquettes (40) à circuits imprimés, dispositif caractérisé par le fait que ledit dispositif pour supprimer des résidus de soudure est formé par une chambre de dépression (43) placée à la face inférieure des plaquettes (40) à circuits imprimés introduites, ainsi que par une pièce insérée (12) qui forme l'orifice d'évacuation par aspiration de ladite chambre de dépression (43) et est adaptée aux dimensions du composant (31) devant être dessoudé ; et par le fait que l'orifice d'évacuation par aspiration de ladite pièce insérée (12) est situé au-dessus de la buse de soudage (9) et à une distance de cette dernière telle que soit formée une limitation du flux de soudure qui s'écoule au-dessous de ladite pièce insérée (12).

2. Dispositif selon la revendication 1, caractérisé par le fait que la chambre de dépression (43) est constituée par un carter (15) formant un appareil de soudage (8) présentant une buse de soudage (9) en vue d'engendrer le flux de soudure d'un écoulement de dessoudage, ainsi que par un châssis de masquage (10) qui est situé à distance de ladite buse de soudage (9), est placé hermétiquement sur cette dernière et loge la pièce insérée (12), ladite chambre étant reliée à un dispositif (23) destiné à engendrer la dépression.

3. Dispositif selon la revendication 2, caractérisé par le fait que le châssis de masquage (10) est monté levable et abaissable et est doté d'un orifice associé à un cache rapporté remplaçable (11) qui reçoit la pièce insérée (12).

4. Dispositif selon la revendication 3, caractérisé par le fait que la pièce insérée (12) est réalisée en acier avec une paroi en fer doux.

5. Dispositif selon la revendication 2 ou 3, caractérisé par le fait que le châssis de masquage (10) et le cache rapporté (11) sont réalisés en une résine époxyde.

6. Dispositif selon l'une quelconque des revendications précédentes, caractérisé par le fait qu'un projecteur de marquage (7) est installé au-dessus du cache rapporté (12) en vue de caractériser, au moyen d'une image de marquage, le composant (31) devant être dessoudé.

_FIG.1_

1

FIG. 2

FIG. 3

_FIG.4_

_FIG.5_

_FIG.6_